# EUROPEAN PATENT APPLICATION

(11) **EP 2 713 514 A1**
(43) Date of publication of application: **02.04.2014**
(21) Application number: 13184582.8
(22) Date of filing: 16.09.2013
(51) Int. Cl.: H03K 17/12, H02M 7/00, H02M 7/81

(54) **Systems, methods, and apparatus for a gate driver circuit for an alternative energy power supply**

(30) Priority: 28.09.2012 US 201213630763
(71) Applicant: General Electric Company, Schenectady, New York 12345 (US)
(72) Inventor: Wagoner, Robert Gregory, Salem, VA Virginia 24153 (US); Lovell, Alan Carroll, Salem, VA Virginia 24153 (US)
(74) Representative: Picker, Madeline Margaret

(57) **Abstract**

Certain embodiments of the disclosure may include systems, methods and apparatus for providing a gate driver circuit for an alternative energy power supply. According to an example embodiment of the disclosure, a gate drive circuit (310) for an alternative energy power supply is provided. The gate drive circuit includes one or more switching device units (210) operated in parallel. The gate driver circuit (310) is configured to selectively control multiple switching devices (270, 272, 274) in order to balance currents between each of the parallel-connected switching devices.

## Description

This disclosure generally relates to power converters, and more particularly to, systems, methods and apparatus for providing a gate driver circuit for an alternative energy power supply.

A power system, such as, for instance, a power converter system, may include several power semiconductor devices, such as, for instance, multiple insulated gate bipolar transistors (IGBTs), integrated gate commutated thyristors (IGCTs or GCTs), metal oxide semiconductor field effect transistors (MOSFETs), etc., which may coupled in parallel to generate a desired power output rating. However, when power semiconductor devices are operated in parallel, currently flowing to and from these devices may be uneven and flow on the outside branches, leading to stress to the device. This can cause limitation in total output current by the highest stressed device, and the lower stressed devices may not achieve their full capability, leading to reduced output capability and higher cost.

Some or all of the needs may be addressed by certain embodiments of the disclosure. Certain embodiments of the disclosure may include systems, methods, and apparatus for providing a gate driver circuit for an alternative energy power supply. In one embodiment, a gate drive circuit may include one or more switching device units, each including a first, a second, and a third set of power semiconductor devices. The gate driver circuit can be configured to selectively control each of the first, the second, and the third set of power semiconductor devices via a channel in order to balance currents in each of the first, the second, and the third sets of power semiconductor devices.

In another embodiment, a method may be provided. The method may include providing at least one power source. The method may further include providing at least one power semiconductor device including a first, a second and a third set of power semiconductors devices. The method may also include providing at least one gate drive circuit for selectively providing power from the power source to each of the first, the second and the third set of power semiconductor devices via the channel. Further, the method may include selectively providing power via the channel to the first set of power semiconductor devices to output power at a first phase, the second set of power semiconductor devices to output power at a second phase and a third set of power semiconductor devices to output power at a third phase.

In yet another embodiment, a system may be provided. The system may include a power source configured to provide power to one or more switching device units. Each of the switching device units can include a first, a second, and a third set of power semiconductor devices. The gate drive circuit can include at least one controller configured to control each of the first, the second, and the third set of power semiconductor devices via a channel in order to output power at a first, a second, and a third phase.

Other embodiments, features, and aspects of the disclosure are described in detail herein and are considered a part of the claims. Other embodiments, features, and aspects can be understood with reference to the following detailed description, accompanying drawings, and claims.

Reference will now be made to the accompanying tables and drawings, which are not necessarily drawn to scale, and wherein:
FIG. 1 is a schematic representation of an example conventional power system 100 that includes a power converter system comprising multiple IGBTs.
FIG. 2 is a graphical view of conventional operations associated with an example conventional gate drive circuit for controlling multiple IGBTs.
FIG. 3 is a graphical view of one or more gate driver circuits associated with controlling multiple IGBTs in an embodiment of the disclosure.
FIG. 4 is a graphical view of example operations associated with example gate drive circuit for controlling multiple IGBTs according to an embodiment of the disclosure.
FIG. 5 is a flow diagram of an example method for controlling multiple IGBTs according to an embodiment of the disclosure.

Embodiments of the disclosure are described more fully hereinafter with reference to the accompanying drawings, in which embodiments of the disclosure are shown. This disclosure may, however, be embodied in many different forms and should not be construed as limited to the embodiments set forth herein; rather, these embodiments are provided so that this disclosure will be thorough and complete, and will fully convey the scope of the disclosure to those skilled in the art. Like numbers and combinations of letters and numbers refer to like elements throughout.

Certain example embodiments described herein relate to providing one or more gate driver circuits for an alternative energy power supply. In one embodiment, systems, methods, and apparatus for controlling one or more IGBTs can be provided using a gate driver control circuit that provides for balanced current sharing between interconnected IGBTs. Various embodiments are described with reference to IGBTs, however, it will be appreciated that any suitable power semiconductor device including, but not limited to, a metal oxide semiconductor field effect transistor (MOSFET), a bipolar junction transistor, a pseudomorphic high electron mobility transistor (pHEMT), a heterojunction bipolar transistor (HBT), may be implemented with various embodiments of the disclosure.

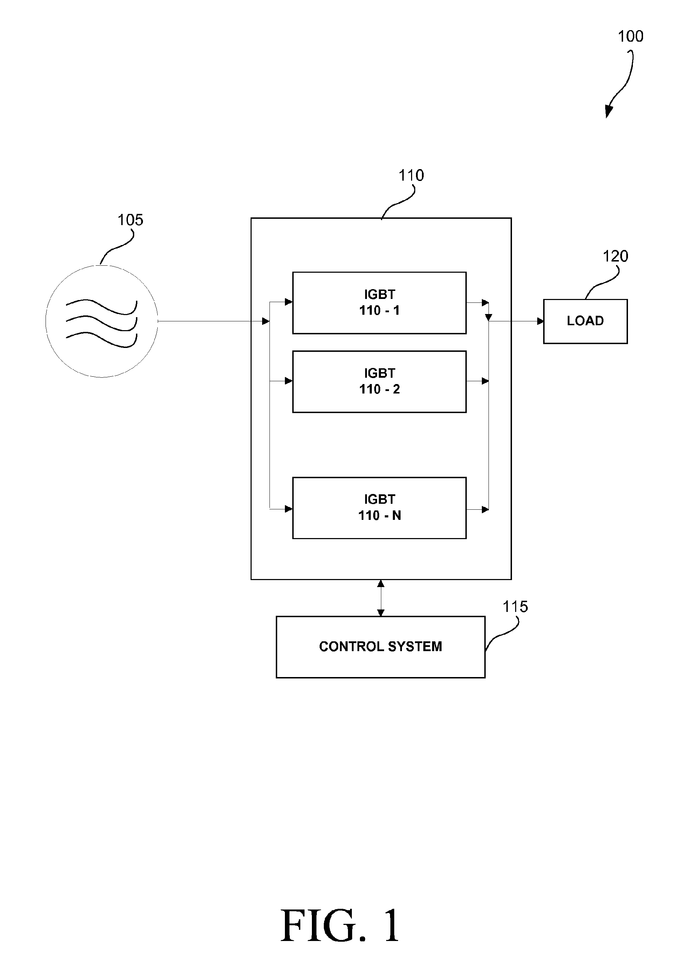

Referring now to FIG. 1, shown is a schematic representation of a conventional power system 100 including a power converter system 110. The power converter system 110 may be configured to supply power to a load 120. The power supplied may be generated by a power source 105 and subsequently provided to the power converter system 110. The power converter system 110 may comprise IGBTs 110-1 through 110-N, which may be coupled in parallel and configured to receive power from the power source 105. The power converter system 110 may convert the received power and provide it to the load 120. The load 120 may include power grids, motors, resistive loads, and the like.

With continued reference to FIG. 1, the power system 100 may also comprise a control system 115. The control system 115 may be coupled to the power converter system 110 and configured to provide control signals to provide for synchronous gating of multiple IGBTs connected in parallel according to one or predefined switching patterns. In conventional control systems, multiple IGBTs operating in parallel are controlled by a single gate drive circuit and a power source to generate one phase of a three phase power system.

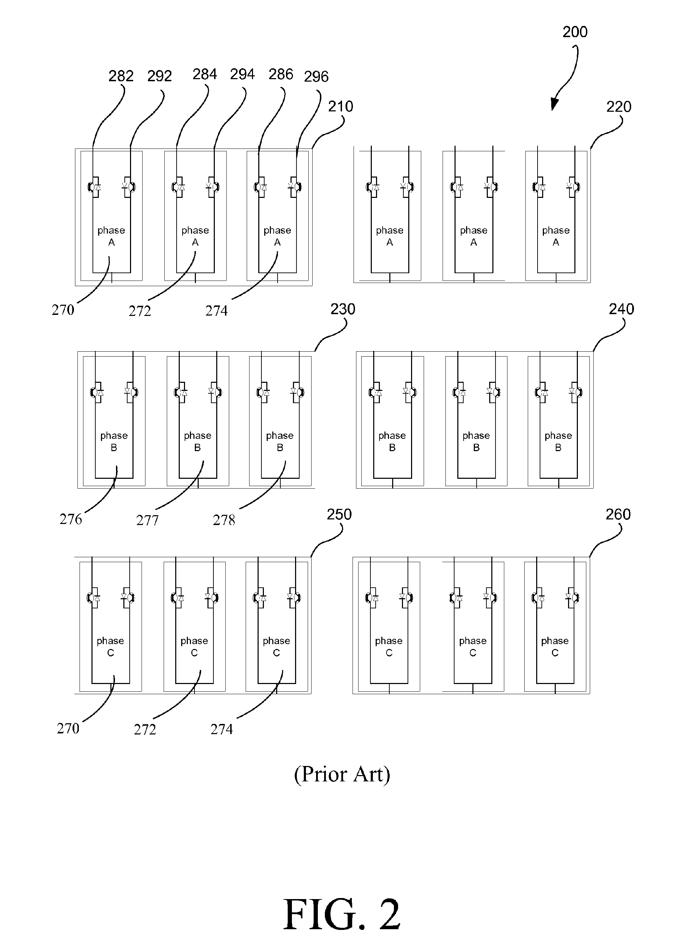

To illustrate, shown in FIG. 2 is a graphical view of conventional operations associated with a control system 200 that includes a conventional gate drive circuit for controlling multiple IGBTs in a six-leg transformer. As shown, a six-leg transformer may comprise one or more switching device units 210, 220, 230, 240, 250 and 260, where each unit may comprise three blocks, such as, blocks 270, 272 and 274 in unit 210, and where each block may comprise two IGBTS. Each of the blocks, such as, blocks 270, 272, 274 may have positive terminals 280, 282 and 284 that are paired together, as are the negative terminals 290, 292 and 294.

In conventional gate drive technology, a control signal may be transmitted, via a switchable current path, to positive terminals in units 210, 220 to generate power phase A; to positive terminals to units 230, 240 to generate power phase B; and positive terminals in units 250, 260 to generate power phase C. However, as described above, in such configurations, there is a tendency of the current to flow on the outside branches of the parallel IGBTs, causing stress to the IGBTs. Additionally, due to propagation delays, a single date driver circuit may have command gate timing issues.

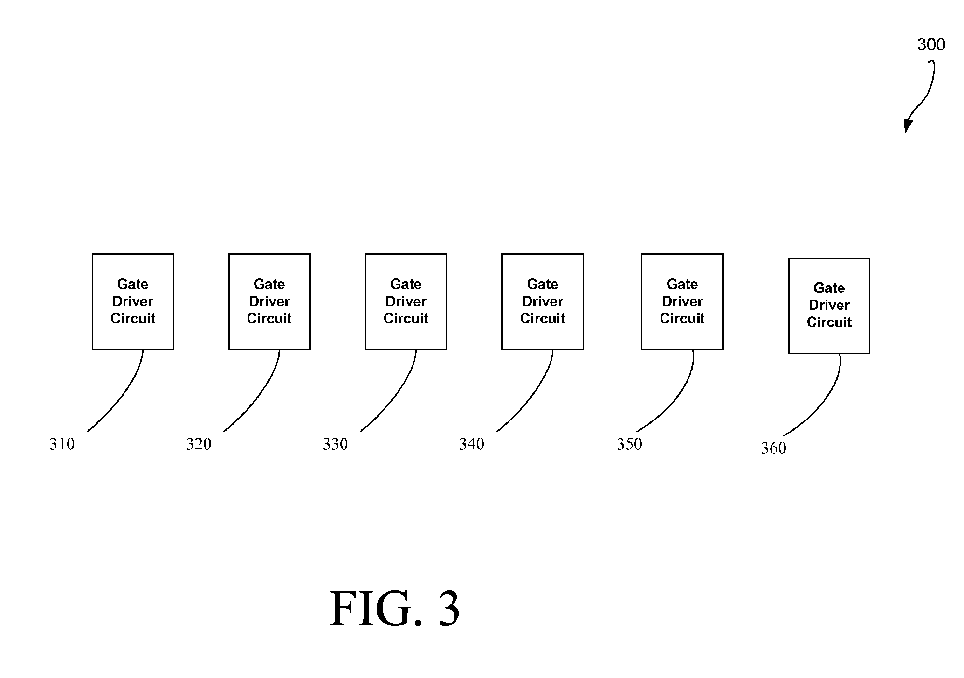

Accordingly, various embodiments are directed to providing balanced parallel current between multiple IGBTs being operated a power system. To do so, a control system 300 may incorporate six gate driver circuits 310, 320, 330, 340, 350 and 360, each connected in series, as shown in FIG. 3. In one embodiment, each of the gate driver circuits 310-360 is configured to output a control signal to a respective set of IGBTs in a respective block of a respective switching device unit.

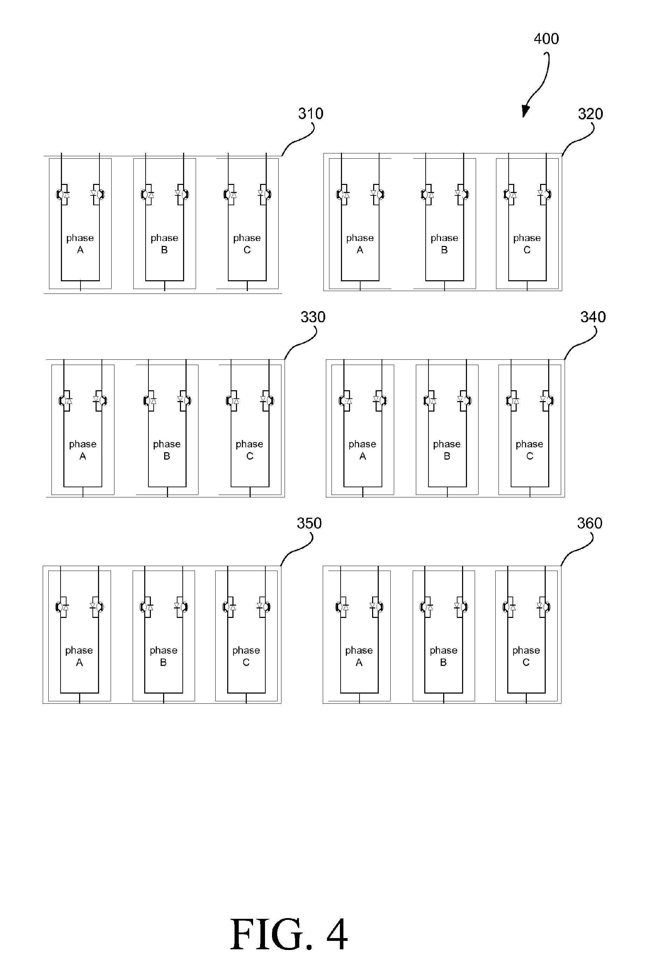

For instance, referring to FIG. 2 and FIG. 3, gate driver circuit 310 may be configured to transmit a control signal to a set of IGBTs in block 270 of unit 210, a set of IGBTs in block 276 in unit 240 and set of IGBTs in block 270 of unit 280. Similarly, gate driver circuit 320 may be configured to transmit a control signal to a set of IGBTs in block 272 of unit 210, set of IGBTs in block 278 in unit 240 and set of IGBTs in block 280 of unit 280, and so on. Accordingly, as shown in FIG. 4, six different gate driver circuits, 310, 320, 330, 340, 350 and 360 may control three blocks of multiple IGBTs to generate each phase of a three phase power system. In such configurations, the tendency of the current to flow on the outside branches of the parallel IGBTs may be reduced, thereby improving the balance of current flow among parallel IGBTs. Therefore, one technical effect of certain embodiments of the disclosure is to improve the balance of current flow among parallel IGBTs in a power system.

Still referring to FIG. 3, for purposes of power output and control, each of the gate driver circuits 310-360 may include logic in a processor and application software running thereof that may propagate the appropriate control signal pertaining to its own control for each phase of power. In some embodiments, gate driver circuit 310 may also include control for n-1 gate driver circuits (i.e. 320-360) that are connected in series. Accordingly, the gate driver unit 310 also includes means for receiving turn-on and turn-off commands for the multiple IGBTs its controlling, and may include logic in a processor and application software running thereof that may propagate the appropriate control signal pertaining to drive each leg of multiple IGBTs of gate driver circuits 320-360 to form a gate drive circuit with a daisy chain command configuration. Such configurations, may transmit signals at the speed of light, limiting propagation delay and improving reliability of the system.

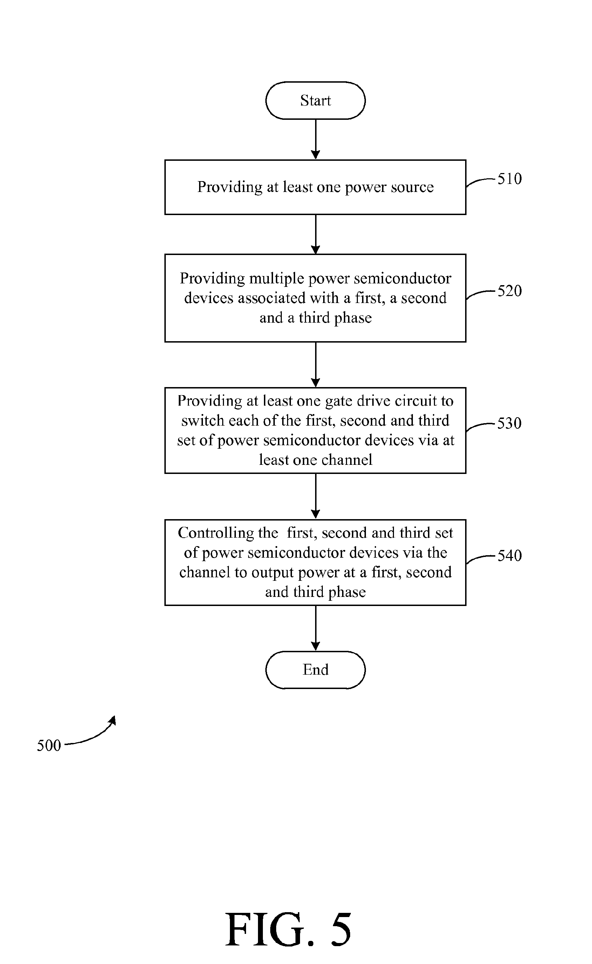

Referring now to FIG. 5, shown is a flow diagram of an example method 500 according to an example embodiment of the disclosure. The method 500 may be implemented by a power system, such as, a six-leg transformer as shown in FIG. 4. The method 500 may start in block 510 with providing a power source, which may be configured to provide power to one or more components of a power system. Thereafter, in block 520, the method 500 can include providing one or more power semiconductor devices, such as IGBTs, which may be, for instance, operated together in one or more sets in order to generate power at a first, a second, and a third phase. Thereafter, in block 530, the method can include providing six or more gate drive circuits configured to control three blocks of multiple IGBTs for each phase of a system by, for instance, communicating control signals via at least one channel that transmits, for example, at the speed of light, a respective signal controlling the parallel IGBTs in a first, a second, and a third set to output power at a first, a second, and a third phase. The method 500 can end after block 530.

References are made to block diagrams of systems, methods, apparatuses, and computer program products according to example embodiments of the disclosure. It will be understood that at least some of the blocks of the block diagrams, and combinations of blocks in the block diagrams, respectively, may be implemented at least partially by computer program instructions. These computer program instructions may be loaded onto a general purpose computer, special purpose computer, special purpose hardware-based computer, or other programmable data processing apparatus to produce a machine, such that the instructions which execute on the computer or other programmable data processing apparatus create means for implementing the functionality of at least some of the blocks of the block diagrams, or combinations of blocks in the block diagrams discussed.

These computer program instructions may also be stored in a computer-readable memory that can direct a computer or other programmable data processing apparatus to function in a particular manner, such that the instructions stored in the computer-readable memory produce an article of manufacture including instruction means that implement the function specified in the block or blocks. The computer program instructions may also be loaded onto a computer or other programmable data processing apparatus to cause a series of operational steps to be performed on the computer or other programmable apparatus to produce a computer implemented process such that the instructions that execute on the computer or other programmable apparatus provide steps for implementing the functions specified in the block or blocks.

One or more components of the systems and one or more elements of the methods described herein may be implemented through an application program running on an operating system of a computer. They also may be practiced with other computer system configurations, including hand-held devices, multiprocessor systems, microprocessor based or programmable consumer electronics, mini-computers, mainframe computers, and so forth.

Application programs that are components of the systems and methods described herein may include routines, programs, components, data structures, and the like, that implement certain abstract data types and perform certain tasks or actions. In a distributed computing environment, the application program (in whole or in part) may be located in local memory or in other storage. In addition, or as an alternative, the application program (in whole or in part) may be located in remote memory or in storage to allow for circumstances where tasks are performed by remote processing devices linked through a communications network.

It will be appreciated that the technology described herein may be embodied in many forms and should not be limited to the example embodiments described above. Therefore, it is to be understood that the disclosure is not to be limited to the specific embodiments disclosed and that modifications and other embodiments are intended to be included within the scope of the appended claims. Although specific terms are employed herein, they are used in a generic and descriptive sense only and not for purposes of limitation.

Various aspects and embodiments of the present invention are defined by the following numbered clauses:
1. A gate driver circuit for an alternative energy power supply, comprising:
   a plurality of switching device units, wherein each of the plurality of switching device units comprises a first, a second and a third set of power semiconductor devices,
   and wherein the gate driver circuit selectively controls each of the first, the second and the third set of power semiconductor devices via a channel to output power at a first, a second, and a third phase in order to balance currents in each of the first, the second and the third sets of power semiconductor devices.
2. The gate driver circuit of clause 1, wherein the first set of power semiconductor devices of each of the plurality of switching device units are connected in series, and wherein the second set of power semiconductor devices of each of the plurality of switching device units are connected in series, and wherein the third set of power semiconductor devices of each of the plurality of switching device units are connected in series.
3. The gate driver circuit of any preceding clause, wherein the first set of power semiconductor devices of each of the plurality of switching device units output power at the first phase, and wherein the second set of power semiconductor devices of each of the plurality of switching device units output power at the second phase, and the third set of power semiconductor devices of each of the plurality of switching device units output power at the third phase.
4. The gate driver circuit of any preceding clause, wherein each of the first, the second and the third set of power semiconductor devices of each of the plurality of switching device units comprises a first power semiconductor device and a second power semiconductor device.
5. The gate driver circuit of any preceding clause, wherein the first power semiconductor device and the second power semiconductor device are connected in parallel.
6. The gate driver circuit of any preceding clause, wherein the channel comprises at least one of (i) a copper connection; or (ii) a fiber optic connection.
7. The gate driver circuit of any preceding clause, wherein information associated with each of the first, the second, and the third set of power semiconductor devices of each of the plurality of switching device units is communicated to the gate driver circuit via the channel.
8. The gate driver circuit of any preceding clause, wherein at least one of the power semiconductor devices is at least one of (i) an insulated gate bipolar transistor (IGBT) or (ii) a metal oxide semiconductor field effect transistor (MOSFET).
9. The gate driver circuit of any preceding clause, wherein the plurality of switching device unit comprises six switching device units.
10. The gate driver circuit of any preceding clause, wherein the gate driver circuit selectively controls each of the first, the second and the third set of power semiconductor devices based at least in part on a control parameter, the control parameter comprising at least one of (i) a time reference or (ii) reference information associated with each of the first, the second, and the third set of power semiconductor devices.
11. A system, comprising:
   at least one power source configured to provide power to a plurality of switching device units each comprising a first, a second, and a third set of power semiconductor devices, wherein each of the first, the second, and the third sets of power semiconductor devices are controlled by a gate driver via one or more channels, the gate driver comprising:
      at least one controller configured to control each of the first, the second and the third set of power semiconductor devices via a channel to output power at a first, a second, and a third phase in order to balance currents in each of the first, the second and the third set of power semiconductor devices.
12. The system of any preceding clause, wherein the first set of power semiconductor devices of each of the plurality of switching device units are connected in series, and wherein the second set of power semiconductor devices of each of the plurality of switching device units are connected in series, and wherein the third set of power semiconductor devices of each of the plurality of switching device units are connected in series.
13. The system of any preceding clause, wherein the first set of power semiconductor devices of each of the plurality of switching device units output power at the first phase, and wherein the second set of power semiconductor devices of each of the plurality of switching device units output power at the second phase, and wherein the third set of power semiconductor devices of each of the plurality of switching device units output power at the third phase.
14. The system of any preceding clause, wherein each of the first, the second and the third set of power semiconductor devices of each of the plurality of switching device units comprises a first power semiconductor device and a second power semiconductor device.
15. The system of any preceding clause, wherein the first power semiconductor device and the second power semiconductor device is connected in parallel.
16. The system of any preceding clause, wherein information associated with each of the first, the second and the third set of power semiconductor devices of each of the plurality of switching device units is communication to the gate driver circuit via the one or more channels.
17. A method, comprising:
   providing at least one power source;
   providing at least one power semiconductor device, wherein the at least one semiconductor device comprises a first, a second and a third set of power semiconductors; and
   providing at least one gate drive circuit for selectively providing power from at least one power source to switch each of the first, the second and the third set of power semiconductor devices via at least one channel; and
   selectively providing power via the at least one channel to the first set of power semiconductor devices to output power at a first phase, the second set of power semiconductor devices to output power at a second phase and a third set of power semiconductor devices to output power at a third phase.
18. The method of any preceding clause, wherein each of the first, the second and the third sets of power semiconductor devices comprises a first power semiconductor device and a second power semiconductor device.
19. The method of any preceding clause, wherein the first power semiconductor device and the second power semiconductor device is connected in parallel.
20. The method of any preceding clause, wherein the least one of the power semiconductor device is at least one of (i) an insulated gate bipolar transistor or (ii) a metal oxide semiconductor field effect transistor (MOSFET).

## Claims

1. A gate driver circuit (310) for an alternative energy power supply, comprising:
a plurality of switching device units (210), wherein each of the plurality of switching device units comprises a first (270), a second (272) and a third (274) set of power semiconductor devices,
and wherein the gate driver circuit (310) selectively controls each of the first (270), the second (272) and the third (274) set of power semiconductor devices via a channel to output power at a first, a second, and a third phase in order to balance currents in each of the first, the second and the third sets of power semiconductor devices.

2. The gate driver circuit of claim 1, wherein the first set of power semiconductor devices (270) of each of the plurality of switching device units (210) are connected in series, and wherein the second set of power semiconductor devices (272) of each of the plurality of switching device units (210) are connected in series, and wherein the third set of power semiconductor devices (274) of each of the plurality of switching device units (210) are connected in series.

3. The gate driver circuit of claim 1 or claim 2, wherein the first set of power semiconductor devices (270) of each of the plurality of switching device units (210) output power at the first phase, and wherein the second set of power semiconductor devices (272) of each of the plurality of switching device units (210) output power at the second phase, and the third set of power semiconductor devices (274) of each of the plurality of switching device units (210) output power at the third phase.

4. The gate driver circuit of claim 1, 2 or 3, wherein each of the first (270), the second (272) and the third (274) set of power semiconductor devices of each of the plurality of switching device units (210) comprises a first power semiconductor device and a second power semiconductor device, wherein, preferably, the first power semiconductor device and the second power semiconductor device are connected in parallel.

5. The gate driver circuit of any preceding claim, wherein the channel comprises at least one of (i) a copper connection; or (ii) a fiber optic connection, wherein, preferably, information associated with each of the first (270), the second (272), and the third (274) set of power semiconductor devices of each of the plurality of switching device units (210) is communicated to the gate driver circuit (310) via the channel.

6. The gate driver circuit of any preceding claim, wherein at least one of the power semiconductor devices is at least one of (i) an insulated gate bipolar transistor (IGBT) or (ii) a metal oxide semiconductor field effect transistor (MOSFET).

7. The gate driver circuit of any preceding claim, wherein the gate driver circuit (310) selectively controls each of the first (270), the second (272) and the third (274) set of power semiconductor devices based at least in part on a control parameter, the control parameter comprising at least one of (i) a time reference or (ii) reference information associated with each of the first, the second, and the third set of power semiconductor devices.

8. A system, comprising:
at least one power source (105) configured to provide power to a plurality of switching device units (210) each comprising a first (270), a second (272), and a third (274) set of power semiconductor devices, wherein each of the first, the second, and the third sets of power semiconductor devices are controlled by a gate driver (310) via one or more channels, the gate driver comprising:
at least one controller (115) configured to control each of the first (270), the second (272) and the third (274) set of power semiconductor devices via a channel to output power at a first, a second, and a third phase in order to balance currents in each of the first, the second and the third set of power semiconductor devices.

9. The system of claim 8, wherein the first set of power semiconductor devices (270) of each of the plurality of switching device units (210) are connected in series, and wherein the second set of power semiconductor devices (272) of each of the plurality of switching device units (210) are connected in series, and wherein the third set of power semiconductor devices (274) of each of the plurality of switching device units (210) are connected in series.

10. The system of claim 8 or claim 9, wherein the first set of power semiconductor devices (270) of each of the plurality of switching device units (210) output power at the first phase, and wherein the second set of power semiconductor devices (272) of each of the plurality of switching device units (210) output power at the second phase, and wherein the third set of power semiconductor devices (274) of each of the plurality of switching device units (210) output power at the third phase.

11. The system of claim 8, 9 or 10, wherein each of the first (270), the second (272) and the third (274) set of power semiconductor devices of each of the plurality of switching device units (210) comprises a first power semiconductor device and a second power semiconductor device, wherein, preferably, the first power semiconductor device and the second power semiconductor device is connected in parallel.

12. The system of any one of claims 8 to 11, wherein information associated with each of the first (270), the second (272) and the third (204) set of power semiconductor devices of each of the plurality of switching device units (210) is communication to the gate driver circuit via the one or more channels.

13. A method, comprising:
providing (510) at least one power source;
providing (520) at least one power semiconductor device, wherein the at least one semiconductor device comprises a first, a second and a third set of power semiconductors; and
providing (530) at least one gate drive circuit for selectively providing power from at least one power source to switch each of the first, the second and the third set of power semiconductor devices via at least one channel; and
selectively providing power via the at least one channel to the first set of power semiconductor devices to output power at a first phase, the second set of power semiconductor devices to output power at a second phase and a third set of power semiconductor devices to output power at a third phase.

14. The method of claim 13, wherein each of the first, the second and the third sets of power semiconductor devices comprises a first power semiconductor device and a second power semiconductor device, wherein, preferably, the first power semiconductor device and the second power semiconductor device is connected in parallel.

15. The method of claim 13 or claim 14, wherein the least one of the power semiconductor device is at least one of (i) an insulated gate bipolar transistor or (ii) a metal oxide semiconductor field effect transistor (MOSFET).
